(19) Europäisches Patentamt
European Patent Office
Office européen des brevets

(11) **EP 3 912 808 A1**

(12) **EUROPÄISCHE PATENTANMELDUNG**

(43) Veröffentlichungstag:
**24.11.2021 Patentblatt 2021/47**

(51) Int Cl.:
***B32B 17/10*** *(2006.01)*

(21) Anmeldenummer: **21169056.5**

(22) Anmeldetag: **19.04.2021**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **21.04.2020 DE 102020205028**

(71) Anmelder: **Implanta Beteiligungs-GmbH**
**48149 Münster (DE)**

(72) Erfinder: **Haverkamp, Ulrich**
**48149 Münster (DE)**

(74) Vertreter: **Rau, Schneck & Hübner**
**Patentanwälte Rechtsanwälte PartGmbB**
**Königstraße 2**
**90402 Nürnberg (DE)**

(54) **MEHRLAGIGER SCHUTZGLASVERBUND, ANZEIGEVORRICHTUNG MIT EINEM FORMFLEXIBLEN ANZEIGEELEMENT UND EINEM DARAN BEFESTIGTEN DERARTIGEN SCHUTZGLASVERBUND SOWIE VERWENDUNG EINER DÜNNGLASLAGE ALS SCHUTZGLAS**

(57) Ein mehrlagiger Schutzglasverbund umfasst mindestens eine Dünnglaslage (8, 9) und eine mit der mindestens einen Dünnglaslage (8, 9) verbundene Polymerschicht (10), wobei der Schutzglasverbund (3) eine Dicke (D) aufweist, die kleiner ist als 1000 $\mu$m.

Fig. 2

**Beschreibung**

Der Inhalt der deutschen Patentanmeldung DE 10 2020 205 028.7 wird durch Bezugnahme hierin aufgenommen.

Die Erfindung betrifft einen mehrlagigen Schutzglasverbund, eine Anzeigevorrichtung mit einem formflexiblen Anzeigeelement und einem daran befestigten derartigen Schutzglasverbund sowie Verwendung einer Dünnglaslage als Schutzglas.

Ein formflexibles Anzeigeelement ist beispielsweise in Form eines klappbaren Smartphones bekannt, das zwei zueinander klappbare Displays aufweist. In einem aufgeklappten Zustand bilden die beiden Displays eine gemeinsame, miteinander verbundene Anzeigefläche. Die beiden Displays wirken wie ein gemeinsames, vergrößertes Display. Ein klappbares Smartphone kann auch ein einziges, durchgängiges, formflexibles Display aufweisen. Ein derartiges Smartphone wird beispielsweise derzeit von dem Unternehmen Samsung mit der Bezeichnung "Galaxy Z Flip" oder von dem Unternehmen LG mit der Bezeichnung "G8X Thin Q Dual Screen" angeboten. Formflexible Anzeigeelemente sind auch in Form von aufrollbaren Fernsehern oder faltbaren Laptops bekannt.

Um derartige formflexible Anzeigeelemente vor Beschädigung und/oder Zerstörung zu schützen, sind formflexible Schutzfolien bekannt, die auf das jeweilige Anzeigeelement aufgebracht werden. Die Widerstandsfähigkeit der Schutzfolie, insbesondere gegen Verkratzen, die sogenannte Kratzbeständigkeit, ist gering. Um die Kratzbeständigkeit zu steigern, kann eine sogenannte Hartbeschichtung, die auch als Hard Coat bezeichnet wird, auf die Schutzfolie aufgebracht werden. Trotz der Hartbeschichtung ist die Kratzbeständigkeit eingeschränkt.

Es ist eine Aufgabe der vorliegenden Erfindung, den Schutz gegen Verkratzen zu verbessern, insbesondere die Kratzbeständigkeit zu erhöhen, insbesondere eine Barriere gegen Feuchtigkeit bereitzustellen und insbesondere Optik und/oder Haptik des Schutzes zu verbessern, wobei insbesondere die Formflexibilität nicht eingeschränkt sein soll.

Diese Aufgabe ist erfindungsgemäß gelöst durch einen mehrlagigen Schutzglasverbund mit den im Anspruch 1 angegebenen Merkmalen, durch eine Anzeigevorrichtung mit den im Anspruch 14 angegebenen Merkmalen sowie durch die Verwendung einer Dünnglaslage mit den im Anspruch 15 angegebenen Merkmalen.

Erfindungsgemäß wurde erkannt, dass ein mehrlagiger Schutzglasverbund mit mindestens einer Dünnglaslage und einer daran befestigten Polymerschicht einerseits eine hohe Kratzbeständigkeit aufweist und andererseits formflexibel ausgeführt ist. Der erfindungsgemäße Schutzglasverbund ist mit einer reduzierten Dicke ausgeführt, die kleiner ist als 1000 $\mu$m. Insbesondere ist die Dicke des Schutzglasverbundes kleiner als 800 $\mu$m, insbesondere kleiner als 700 $\mu$m, insbesondere kleiner als 600 $\mu$m, insbesondere kleiner als 500 $\mu$m, insbesondere kleiner als 400 $\mu$m, insbesondere kleiner als 300 $\mu$m, insbesondere kleiner als 250 $\mu$m, insbesondere kleiner als 220 $\mu$m, insbesondere kleiner oder gleich 210 $\mu$m, insbesondere kleiner als 200 $\mu$m, insbesondere kleiner als 180 $\mu$m, insbesondere kleiner als 160 $\mu$m, insbesondere kleiner als 140 $\mu$m, insbesondere kleiner als 120 $\mu$m, insbesondere kleiner als 100 $\mu$m, insbesondere kleiner als 80 $\mu$m, insbesondere kleiner als 60 $\mu$m, insbesondere kleiner als 40 $\mu$m, insbesondere kleiner als 20 $\mu$m, insbesondere kleiner als 10 $\mu$m und insbesondere kleiner als 5 $\mu$m. Aufgrund der reduzierten Dicke ist die Strukturflexibilität des Schutzglasverbundes erhöht. Der Schutzglasverbund ist im Ausgangszustand ein flächiges Gebilde mit einer Länge und einer Breite, die jeweils eindeutig größer sind als die Dicke des Schutzglasverbundes. Insbesondere betragen Länge und/oder Breite mindestens das Einhundertfache, insbesondere mindestens das Zweihundertfache, insbesondere mindestens das Vierhundertfache, insbesondere mindestens das Fünfhundertfache, insbesondere mindestens das Sechshundertfache, insbesondere mindestens das Achthundertfache, insbesondere mindestens das Eintausendfache und insbesondere mindestens das Zweitausendfache. Beispielsweise kann die Länge 12 cm und die Breite 2x6 cm also 12 cm und die Dicke des Schutzglasverbundes etwa 200 $\mu$m betragen. Für diese Ausführungsform betragen Länge und Breite jeweils das 600-fache der Dicke des Schutzglasverbundes. Der mehrlagige Schutzglasverbund kann aus einer flächigen Anordnung in eine räumliche Anordnung deformiert, insbesondere um eine Biegeachse gebogen werden, ohne dass Brüche und/oder Risse an dem mehrlagigen Schutzglasverbund auftreten. Insbesondere tritt auch eine Delamination der Dünnglaslage von der Polymerschicht bei einer derartigen Biegung nicht auf.

Die mindestens eine Dünnglaslage bildet eine äußere Deckschicht des Schutzglasverbundes. Dadurch weist der mehrlagige Schutzglasverbund eine Glasoptik und eine Glashaptik auf. Der mehrlagige Schutzglasverbund wird wie ein einteiliges homogenes Schutzglas wahrgenommen. Der mehrlagige Schutzglasverbund ist hochwertig ausgeführt.

Dadurch, dass die mindestens eine Dünnglaslage eine äußere Deckschicht des Schutzglasverbundes bildet, weist der mehrlagige Schutzglasverbund eine hohe Kratzbeständigkeit auf. Insbesondere weist der Schutzglasverbund einen nach der Mohsschen Härteskala ermittelten Härtegrad von mindestens 7 H, insbesondere von mindestens 8 H und insbesondere von mindestens 9 H und insbesondere von mindestens 10 H auf. Der Härtegrad 9 H entspricht der Härte von Saphirglas.

Die mindestens eine Dünnglaslage bildet eine äußere Barriereschicht und schützt den darunterliegenden Gegenstand, insbesondere ein formflexibles Anzeigeelement, vor Eindringen von Feuchtigkeit. Insbesondere weist die Dünnglaslage eine Wasserdampfdurchlässigkeit gemäß DIN EN ISO 15106 bei 23 °C und 85 % relativer Feuchte von höchstens $10^{-4}$ g/(m$^2 \cdot$ d), insbesondere höchstens $10^{-5}$ g/(m$^2 \cdot$ d), insbesondere höchstens $10^{-6}$ g/(m$^2 \cdot$ d), insbesondere höchstens $10^{-7}$ g/(m$^2 \cdot$ d), insbesondere höchstens $10^{-8}$ g/(m$^2 \cdot$ d), insbesondere höchstens $10^{-9}$ g/(m$^2 \cdot$ d) und insbesondere höchstens $10^{-10}$ g/(m$^2 \cdot$ d) auf.

Dadurch, dass die mindestens eine Dünnglaslage eine äußere Deckschicht des Schutzglasverbundes bildet, kann der Schutzglasverbund unkompliziert und zuverlässig an einem formflexiblen Anzeigeelement angebracht und damit verbunden werden. Die Verbindung des Schutzglasverbundes an dem Anzeigeelement ist langlebig und robust.

Insbesondere weist das Anzeigeelement mindestens ein insbesondere formflexibles Display in Form einer organischen Leuchtdiode auf, die auch als Organic Light Emitting Diode (kurz: OLED) bezeichnet wird. Die organische Leuchtdiode ist ein leuchtendes Dünnschichtbauelement aus organisch halbleitenden Materialien. Für die Herstellung von OLEDs sind keine einkristallinen Materialien erforderlich. Die Herstellung von OLEDs ist gegenüber der von herkömmlichen LED-Displays vereinfacht. Das formflexible Anzeigeelement kann auch als LED-Display oder LCD-Display ausgeführt sein. Insbesondere ist der mehrlagige Schutzglasverbund an dem formflexiblen Anzeigeelement derart angebracht, dass das formflexible Display durch die mindestens eine Dünnglaslage geschützt ist. Bei einer Ausführung des formflexiblen Anzeigeelements als aufrollbarer Fernseher kann es vorteilhaft sein, auch die Rückseite des Anzeigeelements mit dem erfindungsgemäßen Schutzglasverbund auszustatten, um ein Verkratzen der Rückseite des aufrollbaren Fernsehers zu vermeiden.

Der mehrlagige Schutzglasverbund kann insbesondere als Schutz gegen Zerkratzen auch an anderen Gegenständen, insbesondere Möbeln, Fassaden und/oder Glasflächen angebracht werden.

Überraschend hat die Anmelderin gefunden, dass dadurch, dass die mindestens eine Dünnglaslage mit einer Polymerschicht verbunden ist, die Formflexibilität des Schutzglasverbundes erhöht ist. Die Polymerschicht wirkt als mechanische Ausgleichsschicht und kann insbesondere dreidimensionale Spannungen bei einer Deformation des Schutzglasverbundes kompensieren.

Die Polymerschicht umfasst insbesondere ein synthetisches Polymer.

Der Schutzglasverbund ist insbesondere vorspannungsfrei ausgeführt und gewährleistet eine verbesserte Formflexibilität. Dadurch können in Dicken- und/oder in Flächenrichtung des Schutzglasverbundes mechanische Spannungen, insbesondere durch die Polymerschicht, vorteilhaft kompensiert werden. Die Herstellung des vorspannungsfreien Schutzglasverbundes ist unaufwändig und dadurch fehlerunanfällig und kosteneffizient. Vorspannungsfrei bedeutet, dass infolge des Herstellungsprozesses des Schutzglasverbundes keine mechanischen Spannungen an dem unbelasteten Schutzglasverbund vorliegen. Insbesondere können für die Herstellung des Schutzglasverbundes Dünnglaslagen und/oder Polymerschichten als Halbzeuge verwendet werden, die von Halbzeugherstellern in großen Mengen zur Verfügung gestellt werden können. Als Halbzeug wird ein Zwischenprodukt verstanden, das von Rohstoffherstellern zur Weiterverarbeitung zur Verfügung gestellt wird. Die für den Schutzglasverbund erforderlichen Rohstoffe sind, insbesondere kosteneffizient verfügbar.

Insbesondere kann der Schutzglasverbund als Rollenmaterial hergestellt werden. Insbesondere können die mindestens eine Dünnglaslage und/oder die Polymerschicht als Rollenmaterial für den Herstellungsprozess des Schutzglasverbundes zur Verfügung gestellt werden. Der Schutzglasverbund kann in einem kontinuierlichen Laminierprozess als Endlosmaterial hergestellt werden. Die Produktionseigenschaften sind verbessert. Die Effektivität und die Qualität der Herstellung des Schutzglasverbundes sind erhöht. Das Herstellverfahren ist fehlersicher. Die Produktionskosten sind reduziert. Insbesondere kann der Schutzglasverbund mittels eines Schneidwerkzeugs, insbesondere mittels eines $CO_2$-Lasers, insbesondere in einem nachträglichen Fertigungsschritt, auf ein definiertes Maß geschnitten werden. Es sind auch andere Schneidwerkzeuge denkbar, insbesondere Stanzwerkzeuge.

Ein Schutzglasverbund gemäß Anspruch 2 gewährleistet eine anwendungsspezifische Anpassung der Polymerschicht. Dadurch, dass die Polymerschicht aus mindestens einer und insbesondere mehreren Polymerfolien aufgebaut sein kann, können Dicke und/oder Material der Polymerschicht flexibel angepasst werden. Insbesondere weist die Polymerschicht genau eine Polymerfolie auf. Wenn mehrere Polymerfolien vorgesehen sind, insbesondere mindestens zwei, insbesondere mindestens drei, insbesondere mindestens vier, insbesondere mindestens fünf, insbesondere höchstens zehn, insbesondere höchstens fünfzehn, insbesondere höchstens zwanzig, insbesondere höchstens fünfundzwanzig, insbesondere höchstens dreißig, insbesondere höchstens fünfunddreißig und insbesondere höchstens vierzig Polymerfolien, sind jeweils zwei benachbart angeordnete Polymerfolien unmittelbar miteinander verbunden, insbesondere miteinander verklebt. Zum Verkleben einer Polymerfolie mit der mindestens einen Dünnglaslage dient insbesondere eine Kunststofffolie aus Ethylen-Vinylacetat-Copolymer (EVA).

Ein Schutzglasverbund, bei dem die Polymerschicht eine Polymerfolie oder einen Polymerfolienverbund aus mehreren miteinander verbundenen Polymerfolien aufweist, wobei die Polymerfolie oder der Polymerfolienverbund unmittelbar mit der mindestens einen Dünnglaslage verklebt ist, veredelt eine an sich bekannte Folie oder einen Folienverbund zu einer sogenannten Glasfolie, deren Oberflächeneigenschaften denen mit Glas vergleichbar und insbesondere identisch sind. Die Glasfolie weist eine erhöhte Funktionalität auf und kann vielfältig eingesetzt werden. Die Funktionseigenschaften der Glasfolie können durch die für die Polymerschicht verwendete Folie oder den Folienverbund flexibel und individuell eingestellt werden. Insbesondere kann bei dem Schutzglasverbund die Polymerschicht als Folie oder als Folienverbund mit mehreren miteinander verbundenen Einzelfolien ausgeführt sein. Die Folie oder der Folienverbund können Funktionsfolien sein und insbesondere als Sonnenschutz, als Sichtschutz, als Lackschutz, mit elektrischer Leitfähigkeit, mit fotochromen Eigenschaften und/oder als Splitterschutz ausgeführt sein. Die Folie oder der Folienverbund kann insbesondere als Sicherheitsfolie ausgeführt sein, wie sie beispielsweise von der Anmelderin unter der markengeschützten Bezeichnung PROFILON ® hergestellt und vertrieben wird. Ein derartige Folien oder Folienverbünde aufweisender Schutzglasverbund weist insbesondere den Vorteil der höheren Kratzbeständigkeit auf. Durch die Verbindung der Folie oder des Folienverbundes mit dem Dünnglas wird eine kratzresistente Folie geschaffen, deren Oberflächeneigenschaften denen von Glas entsprechen. Ein derartiger Schutzglasverbund weist eine erhöhte Funktionalität auf, weil die äußere Oberfläche wie Glas ist. Eine derartige Folie kann als Glasfolie bezeichnet werden. Die Glasfolie eignet sich in besonderer Weise für die Anwendung auf Möbeloberflächen, Gebäudefassaden, auf Glas-/Fensterflächen und/oder an Fensterprofilen. Die Glasfolie kann auf ebenen und/oder unebenen Flächen angebracht werden. Die Glasfolie kann aus Rollenmaterialien hergestellt und vorteilhaft laminiert werden. Die Glasfolie selbst kann als Rollenmaterial bereitgestellt werden und mittels eines Schneidwerkzeugs, insbesondere mittels eines $CO_2$-Lasers, zugeschnitten werden.

Ein Schutzglasverbund gemäß Anspruch 3 ermöglicht eine unabhängige Anpassung des Materials.

Die mindestens eine Polymerfolie weist ein Kunststoffpolymer auf, das insbesondere Homopolymere und/oder Copolymere umfasst. Die mindestens eine Polymerfolie ist insbesondere eine thermoplastische Polymerfolie. Um thermoplastische Polymerfolien miteinander und/oder mit der mindestens einen Dünnglaslage zu verkleben, dient insbesondere eine separate Klebeschicht insbesondere auf Acrylatbasis. Homopolymere bestehen aus nur einer Monomerart wie Polyethylen (PE), Polypropylen (PP), Polyester wie beispielsweise PET, PBT, PC, oder Polyvinylchlorid (PVC). Copolymere sind aus verschiedenen Monomere aufgebaut wie beispielsweise Acrylnitril-Butadien-Styrol-Copolymer (ABS), Styrol-Acrylnitril (SAN) oder Butylkautschuk.

Es ist auch denkbar, dass die Polymerschicht eine Kunststofffolie aus einem thermoplastischen Elastomer auf Uretanbasis (TPU) Polyvinylbutyral (PVB) oder ein Ethylen-Vinylacetat-Copolymer (EVA) ist. Elastomere Kunststofffolien dienen insbesondere selbst als Klebstoff. Die Verwendung eines zusätzlichen, separaten Klebstoffs ist dadurch entbehrlich. In einem Laminierprozess kann die elastomere Kunststofffolie mit der mindestens einen Dünnglaslage an dem Gegenstand, insbesondere an dem formflexiblen Anzeigeelement, beispielsweise in einem Autoklaven und/oder mittels eines Fügeverfahrens durch Aufbringen von erhöhten Temperaturen und/oder Druck, aufgeschmolzen werden. Die geschmolzene elastomere Kunststofffolie bildet den Klebstoff zwischen dem Gegenstand und der mindestens einen Dünnglaslage. TPU und PVB dienen insbesondere als Klebstoff für die Verklebung von Glas auf Glas, also insbesondere einer Dünnglaslage auf einem Display. EVA dient insbesondere als Klebstoff für Kunststoffe, insbesondere als Polymerschicht, auf der Dünnglaslage. Die Verwendung der elastomeren Kunststofffolien ermöglicht insbesondere eine besonders dünnlagige Ausführung des Schutzglasverbundes.

Ein Schutzglasverbund gemäß Anspruch 4 ermöglicht eine besonders dünnbauende Ausführung.

Ein Schutzglasverbund gemäß Anspruch 5 kann aufgrund seiner Formflexibilität als Rollenmaterial zur Verfügung gestellt und an dem Gegenstand angebracht, insbesondere daran verklebt werden. Der Schutzglasverbund ist insbesondere einteilig ausgeführt. Der Schutzglasverbund kann als Rollenmaterial für die Anbringung, insbesondere an dem formflexiblen Anzeigeelement, bereitgestellt werden. Die Lagerung der Transport und/oder die Handhabung des Schutzglasverbundes ist vereinfacht. Insbesondere ist eine flächige Bereitstellung des Schutzglasverbundes in Form von Platten entbehrlich. Insbesondere kann der rollbare Schutzglasverbund unkompliziert hergestellt werden. Die miteinander zu verbindenden Lagen, insbesondere die mindestens eine Dünnglaslage und die mindestens eine Polymerschicht sowie gegebenenfalls ein lagenförmiges Klebstoffmaterial, können vorteilhaft in einem Laminierprozess als Rollenmaterial bereitgestellt werden. Insbesondere ist eine kontinuierliche Herstellung des Schutzglasverbundes möglich. Die Herstellung des Schutzglasverbundes ist zuverlässig und fehlersicher. Der Schutzglasverbund selbst kann als Halbzeug in Form eines Rollenmaterials bereitgestellt werden.

Ein Schutzglasverbund gemäß Anspruch 6 ermöglicht einen verbesserten Kantenschutz der mindestens einen Dünnglaslage und/oder des Gegenstands, an dem der mehrlagige Schutzglasverbund anzubringen ist, insbesondere an einem formflexiblen Anzeigeelement. Vorteilhaft ist es, wenn die Polymerschicht in Längenund/oder in Breitenrichtung, also in der Fläche, jeweils einen Randüberstand bezüglich der mindestens einen Dünnglaslage aufweist. Insbesondere erstreckt sich der Randüberstand entlang des äußeren Umfangs der Polymerschicht, insbesondere vollständig entlang des äußeren Umfangs der Polymerschicht. Der Randüberstand beträgt jeweils in Längen - und/oder in Breitenrichtung mindestens 0,3 mm, insbesondere mindestens 0,5 mm, insbesondere 1,0 mm, insbesondere 1,5 mm, insbesondere 2 mm, insbesondere mindestens 2,5 mm und insbesondere mindestens 3 mm. Bei der Herstellung des Schutzglasverbundes kann sich der Randüberstand an den Außenkanten der Dünnglaslage umlegen. Der Randüberstand der Polymerschicht bildet eine Schutzschicht für die Dünnglaslage entlang des Umfangs. Der Randüberstand dient als integrierter Kantenschutz. Der Schutzglasverbund und insbesondere die Dünnglaslage weisen dadurch eine erhöhte Robustheit auf. Das Risiko einer Beschädigung, insbesondere der außenliegenden Kanten der Dünnglaslage, ist dadurch reduziert und insbesondere verhindert.

Es ist denkbar, den Schutzglasverbund in einer Form auszuführen, in der sich der Randüberstand der Polymerschicht bereits um die Außenkanten der Dünnglaslage umgelegt hat und als Kantenschutz für die Dünnglaslage dient.

Insbesondere ist die Polymerschicht, die beispielsweise an einer Oberseite der Dünnglaslage befestigt ist, um Außenkanten der Dünnglaslage umgelegt und an einer der Oberseite der Dünnglaslage gegenüberliegenden Unterseite befestigt, insbesondere verklebt. Die Polymerschicht ist definiert an der Dünnglaslage befestigt. Durch den Randüberstand sind die Außenkanten der Dünnglaslage definiert abgedeckt und dadurch geschützt.

Alternativ kann der Schutzglasverbund in einer Form ausgeführt werden, in der der Randüberstand der Polymerschicht noch vorliegt und in einem späteren Fügeprozess mit dem Gegenstand, insbesondere mit einem formflexiblen Anzeigeelement, als Kantenschutz für die mindestens eine Dünnglaslage und/oder das formflexible Anzeigeelement dient. Der Randüberstand kann insbesondere in einen umfangsseitigen Spalt, der zwischen einem Gehäuse und/oder einem Rahmen und dem formflexiblen Anzeigeelement gebildet ist, angeordnet werden.

Es versteht sich, dass der Randüberstand entlang des gesamten äußeren Umfangs der Polymerschicht oder nur bereichsweise, insbesondere entlang einzelner Kanten, insbesondere vollständig oder bereichsweise, insbesondere an gegenüberliegend angeordneten Kanten, ausgeführt sein kann. Alternativ kann die Polymerschicht entlang des äußeren Umfangs in der Fläche bündig mit der mindestens einen Dünnglaslage ausgeführt sein. Die Herstellung des Schutzglasverbundes ist dadurch vereinfacht.

Ein Schutzglasverbund gemäß Anspruch 7 weist eine verbesserte Haptik auf. Dadurch, dass mindestens zwei Dünnglaslagen und eine dazwischen angeordnete und mit den Dünnglaslagen jeweils verbundene Polymerschicht vorgesehen ist, wird der mehrlagige Schutzglasverbund als einteiliges Glaselement aufgefasst. Die Formflexibilität des Schutzglasverbundes ist erhöht. Mit der zweiten Dünnglaslage kann der Schutzglasverbund zuverlässig an einem Gegenstand, insbesondere einem formflexiblen Anzeigeelement, befestigt werden.

Der Schutzglasverbund weist insbesondere genau zwei Dünnglaslagen auf, die jeweils eine äußere Deckschicht des Schutzglasverbundes bilden. Dieser Schutzglasverbund weist einen reduzierten Glasanteil auf. Ein derartiger Schutzglasverbund ist kosteneffizient und leichtbauend ausgeführt.

Es können auch mehr als zwei Dünnglaslagen verwendet werden, insbesondere mindestens drei, insbesondere mindestens vier, insbesondere mindestens fünf, insbesondere mindestens sechs, insbesondere mindestens acht, insbesondere mindestens zehn, insbesondere mindestens zwölf, insbesondere mindestens fünfzehn, insbesondere mindestens zwanzig, insbesondere mindestens fünfundzwanzig, insbesondere mindestens dreißig, insbesondere mindestens fünfunddreißig und insbesondere mindestens vierzig Dünnglaslagen. Vorteilhaft ist es, wenn die jeweils äußere Deckschicht des Schutzglasverbundes durch eine der Dünnglaslagen gebildet ist.

Der Schutzglasverbund ist besonders gut deformierbar. Versuche der Anmelderin haben gezeigt, dass der Schutzglasverbund aus der flächigen Anordnung in eine U-Form um 180° biegbar ist. Insbesondere konnte die Anmelderin nachweisen, dass die freien Schenkel des Schutzglasverbundes in eine U-Form gebogen werden können, wobei der freie Abstand der im Wesentlichen parallel angeordneten freien Schenkel höchstens 5 mm, insbesondere höchstens 4 mm und insbesondere höchstens 3 mm beträgt, wobei die Dicke des derartigen Schutzglasverbundes 210 $\mu$m beträgt. Für diesen Schutzglasverbund sind eine erste und zweite Dünnglaslage mit einer jeweiligen Lagendicke von 35 $\mu$m vorgesehen, wobei eine 100 $\mu$m Polyesterfolie dazwischen angeordnet und jeweils mittels einer 20 $\mu$m Acrylat-Kleberschicht mit den Dünnglaslagen verklebt ist. Es versteht sich, dass ein Schutzglasverbund mit anderer Länge, Breite und/oder Dicke und/oder einem anderen Lagenaufbau, also einer unterschiedlichen Lagenanzahl, unterschiedlichen Lagenmaterialien und/oder unterschiedlichen Lagendicken einen abweichenden Abstand der freien Schenkel aufweist. Für diesen Biegeversuch ergibt sich eine rechnerische elastische Dehngrenze. Diese Dehngrenze wurde in Analogie zu Dreipunkt-Biegeversuch nach DIN EN ISO 178 und DIN EN ISO 14125 ermittelt. Die rechnerische Dehngrenze beträgt insbesondere mehr als 200, insbesondere mehr als 400, insbesondere mehr als 600, insbesondere mehr als 700, insbesondere mehr als 750, insbesondere mehr als 800, insbesondere mehr als 900, insbesondere mehr als 1000 und insbesondere höchstens 5000.

Ein Schutzglasverbund gemäß Anspruch 8 weist eine erhöhte Festigkeit auf. Insbesondere ist jeweils eine Klebeschicht zwischen der ersten Dünnglaslage und der Polymerschicht bzw. zwischen der zweiten Dünnglaslage und der Polymerschicht vorgesehen. Die Klebeschichten können identisch oder unterschiedlich ausgeführt sein. Die Verklebung der mindestens einen Dünnglaslage mit der Polymerschicht kann vollflächig erfolgen. Es ist alternativ denkbar, dass die Verklebung zwischen der Dünnglaslage und der Polymerschicht lediglich bereichsweise ausgeführt ist und sich insbesondere zumindest bereichsweise oder vollständig entlang der äußeren Kanten an einer der Polymerschicht zugewandten Oberfläche erstreckt. Insbesondere betragen die Klebeschichten jeweils eine Schichtdicke von höchstens 1.000 μm, insbesondere höchstens 800 μm, insbesondere höchstens 500 μm, insbesondere höchstens 300 μm, insbesondere höchstens 200 μm, insbesondere höchstens 150 μm, insbesondere höchstens 100 μm, insbesondere höchstens 80 μm, insbesondere höchstens 60 μm, insbesondere höchstens 50 μm, insbesondere höchstens 40 μm, insbesondere höchstens 30 μm, insbesondere höchstens 25 μm, insbesondere höchstens 20 μm, insbesondere höchstens 15 μm, insbesondere höchstens 12 μm, insbesondere höchstens 10 μm, insbesondere höchstens 8 μm, insbesondere höchstens 6 μm, insbesondere höchstens 4 μm und insbesondere höchstens 2 μm.

Eine Ausführung der Klebeschichten gemäß Anspruch 9 gewährleistet eine zuverlässige Verklebung. Der Klebstoff ist insbesondere ein Klebstoff auf Acrylatbasis, insbesondere ein Cyanacrylatklebstoff, also ein Polymerisationsklebstoff. Der Klebstoff ist insbesondere selbstklebend und insbesondere ein Haftkleber. Der Klebstoff ist insbesondere als sogenannter Pressure Sensitive Adhesive, also PSA-Klebstoff, ausgeführt. Der Klebstoff ist insbesondere selbstaushärtend. Alternativ kann ein Klebstoff verwendet werden, der bei einer Bestrahlung mit Licht in einem Wellenlängenbereich zwischen 10 nm und 395 nm, also UV-Strahlung, aushärtet. Als Klebstoff kommen alle an sich bekannten Ein- oder Mehrkomponenten-Klebesysteme in Betracht, die für eine Verklebung von Polymerfolien geeignet sind. Alternativ kann die Polymerschicht unmittelbar mit der mindestens einen Dünnglaslage verbunden, insbesondere verschmolzen werden. In diesem Fall dient die Polymerschicht selbst als Klebeschicht.

Ein Schutzglasverbund gemäß Anspruch 10 ermöglicht eine besonders dünnbauende Ausführung einer Polymerfolie mit Dünnglaslagen. Die erste und/oder zweite Dünnglaslage weisen eine Lagendicke von höchstens 300 μm, insbesondere von höchstens 250 μm, insbesondere von höchstens 200 μm, insbesondere von höchstens 150 μm, insbesondere von höchstens 120 μm, insbesondere von höchstens 100 μm, insbesondere höchstens 90 μm, insbesondere höchstens 75 μm, insbesondere höchstens 60 μm, insbesondere höchstens 50 μm, insbesondere höchstens 45 μm, insbesondere höchstens 40 μm, insbesondere höchstens 35 μm, insbesondere höchstens 30 μm, insbesondere höchstens 25 μm, insbesondere höchstens 20 μm, insbesondere höchstens 15 μm, insbesondere höchstens 12 μm insbesondere höchstens 10 μm, insbesondere höchstens 8 μm und insbesondere höchstens 5 μm. Die Dünnglaslage ist insbesondere bis zu einer Lagendicke von höchstens 300 μm rollbar. Die Dünnglaslagen weisen als Glastyp beispielsweise Borosilikatglas, Alumino-Borosilikatglas, Kalknatronglas, also Normalglas, Aluminosilikat und/oder Lithium-Aluminosilikat auf.

Ein Schutzglasverbund gemäß Anspruch 11 weist einen homogenen und insbesondere bezüglich einer in der Polymerschicht angeordnete Symmetrieebene symmetrischen Lagenaufbau auf. Die Materialeigenschaften sind bezüglich dieser Symmetrieebene symmetrisch ausgeführt.

Alternativ kann ein Schutzglasverbund gemäß Anspruch 12 gezielt einen unsymmetrischen Lagenaufbau mit unsymmetrischen Materialeigenschaften aufweisen. Insbesondere kann die Dünnglaslage, die bei einer durchzuführenden Biegung die innere Faser des Schutzglasverbundes bildet, dünner ausgeführt sein als die Dünnglaslage, die bei der Biegung die äußere Faser bildet. Bei der Biegung wird die äußere Faser mehr gedehnt als die innere Faser. Der Biegevorgang wird dadurch begünstigt. Insbesondere ist der Widerstand der inneren Faser gegen die Biegung reduziert. Insbesondere ist die Widerstandsfähigkeit des Schutzglasverbundes durch die vergleichsweise höhere Dicke der äußeren Faser erhöht. Der Schutzglasverbund ist mit der äußeren Faser, also der dickeren Dünnglaslage an dem formflexiblen Anzeigeelement befestigt. Die innere Faser, also die dünnere Dünnglaslage bildet die äußere Oberfläche des Schutzglasverbundes.

Ein Schutzglasverbund gemäß Anspruch 13 ermöglicht eine vorteilhafte Handhabung für den Nutzer. Dadurch, dass die mindestens eine Dünnglaslage aus Einscheibensicherheitsglas (ESG) hergestellt ist, ist das Verletzungsrisiko für einen Nutzer minimiert. Insbesondere ist die Verletzung eines Nutzers durch Glassplitter verhindert. Einscheibensicherheitsglas weist den Vorteil auf, dass es bei Bruch in viele kleine Bruchstücke zerfällt. Wesentlich ist, dass bei einem Bruch des Einscheibensicherheitsglases sich der Bruch über die gesamte Dicke des Einscheibensicherheitsglases erstreckt. Dadurch, dass die mindestens eine Dünnglaslage mit der Polymerschicht verbunden ist, ist gewährleistet, dass die einzelnen Bruchstücke zuverlässig an der Polymerschicht gehalten sind. Es ist dadurch verhindert, dass sich einzelne Bruchstücke unbeabsichtigt aus dem Schutzglasverbund lösen. Es wurde insbesondere gefunden, dass durch die Ausführung der mindestens einen Dünnglaslage aus Einscheibensicherheitsglas verhindert ist, dass die Dünnglaslage Bruchstücke aufweist, die in Dickenrichtung der Dünnglaslage nicht vollständig durchbrechen und somit in einer Teilschicht ausbrechen. Derartige, in Teilschichten ausgebrochene Bruchstücke können an der Polymerschicht nicht gehalten werden. Derartige Bruchstücke bilden Glassplitter, die insbesondere scharfkantig sind und insbesondere aufgrund ihrer geringen Dicke zu einem erheblichen Verletzungsrisiko für den Nutzer werden können. Dieses Verletzungsrisiko ist bei einem Schutzglasverbund, bei dem die mindestens eine Dünnglaslage aus Einscheibensicherheitsglas hergestellt ist, zuverlässig verhindert.

Wenn der Schutzglasverbund mehrere Dünnglaslagen aufweist, können mehrere Dünnglaslagen und insbesondere alle Dünnglaslagen aus Einscheibensicherheitsglas hergestellt sein. Insbesondere ist die außenliegende Dünnglaslage, die insbesondere an einer einer Anzeigevorrichtung abgewandten Außenseite angeordnet ist, aus Einscheibensicherheitsglas hergestellt.

Eine Anzeigevorrichtung gemäß Anspruch 14 weist im Wesentlichen die Vorteile des erfindungsgemäßen Schutzglasverbundes auf, worauf hiermit verwiesen wird. Der Schutzglasverbund ist insbesondere mit dem formflexiblen Anzeigeelement, das insbesondere ein OLED-Display aufweist, verklebt. Als Klebstoff kann hierfür der Klebstoff verwendet werden, der auch für das Verkleben der Polymerschicht mit den Dünnglaslagen verwendet wird. Insbesondere wird ein Klebstoff auf Acrylatbasis verwendet.

Die Verwendung einer Dünnglaslage als Schutzglas gemäß Anspruch 15 ermöglicht einen besonders effektiven, unkomplizierten, robusten und/oder dünnbauenden Schutz, insbesondere für ein formflexibles Anzeigeelement, insbesondere in Form eines OLED-Displays. Die verwendete Dünnglaslage weist insbesondere eine Lagendicke auf, die höchstens 300 $\mu$m beträgt, insbesondere von höchstens 250 $\mu$m, insbesondere von höchstens 200 $\mu$m, insbesondere von höchstens 150 $\mu$m, insbesondere von höchstens 120 $\mu$m, insbesondere von höchstens 100 $\mu$m, insbesondere höchstens 90 $\mu$m, insbesondere höchstens 75 $\mu$m, insbesondere höchstens 60 $\mu$m, insbesondere höchstens 50 $\mu$m, insbesondere höchstens 45 $\mu$m, insbesondere höchstens 40 $\mu$m und insbesondere höchstens 35 $\mu$m, insbesondere höchstens 30 $\mu$m, insbesondere höchstens 25 $\mu$m, insbesondere höchstens 20 $\mu$m, insbesondere höchstens 15 $\mu$m, insbesondere höchstens 12 $\mu$m insbesondere höchstens 10 $\mu$m, insbesondere höchstens 8 $\mu$m und insbesondere höchstens 5 $\mu$m.

Überraschend hat die Anmelderin gefunden, dass das OLED-Display durch eine einzige Dünnglaslage als Schutzglas ausreichend und zuverlässig geschützt ist. Die zusätzliche Verwendung einer ausliegenden Polymerschicht ist entbehrlich. Dadurch, dass die einzige Dünnglaslage außenliegend angeordnet ist, ist die Kratzbeständigkeit erhöht. Die Dünnglaslage ist insbesondere unmittelbar an dem Anzeigeelement verklebt. Die Anmelderin hat gefunden, dass bei einer mechanischen Einwirkung durch Stöße oder Aufprall die Dünnglaslage in Dickenrichtung komplett durchbricht. Ein Bruchverhalten der Dünnglaslage in mehreren Teilschichten - wie dies bei dickeren Glasscheiben der Fall ist - tritt hier überraschend nicht auf. Die Einzelnen, durchgängigen Splitter sind in der Klebeschicht zuverlässig gehalten.

Eine außenliegende Polymerschicht, die Glassplitter zurückhalten soll, ist deshalb entbehrlich.

Sowohl die in den Patentansprüchen angegebenen Merkmale als auch die in den nachfolgenden Ausführungsbeispielen eines erfindungsgemäßen Schutzglasverbundes angegebenen Merkmale sind jeweils für sich alleine oder in Kombination miteinander geeignet, den erfindungsgemäßen Gegenstand weiterzubilden.

Die jeweiligen Merkmalskombinationen stellen hinsichtlich der Weiterbildungen des Erfindungsgegenstands keine Einschränkung dar, sondern weisen im Wesentlichen lediglich beispielhaften Charakter auf.

Weitere Merkmale, Vorteile und Einzelheiten der Erfindung ergeben sich aus der nachfolgenden Beschreibung von Ausführungsbeispielen anhand der Zeichnung. In dieser zeigen:

Fig. 1 eine schematische perspektivische Darstellung eines formflexiblen Anzeigeelements mit einem daran befestigten mehrlagigen Schutzglasverbund gemäß der Erfindung,

Fig. 2 eine schematische, vergrößerte Schnittansicht gemäß Schnittlinie II-II in Fig. 1,

Fig. 3 eine schematische Darstellung eines Biegeversuches mit dem mehrlagigen Schutzglasverbund gemäß Fig. 1,

Fig. 4 eine Fig. 2 entsprechende Schnittansicht der Verwendung einer einzigen Dünnglaslage als Schutzglas an einem formflexiblen Anzeigeelement.

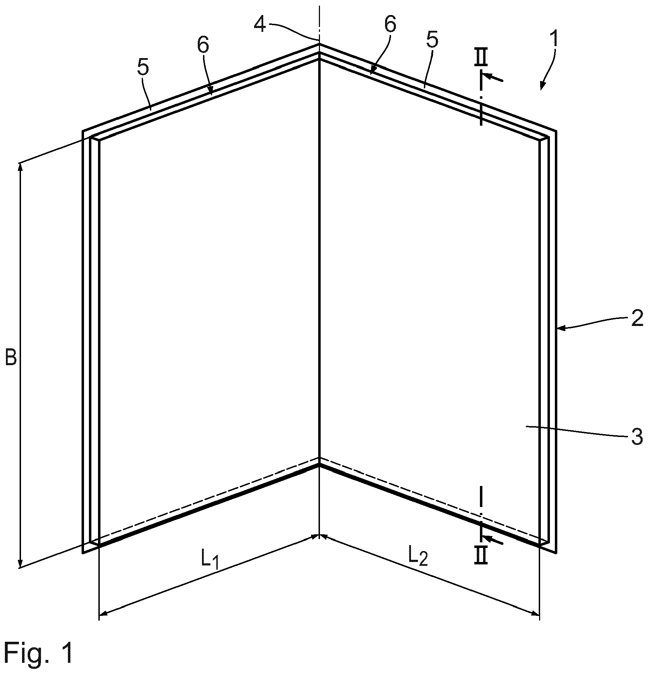

Eine in Fig. 1 als Ganzes mit 1 gekennzeichnete Anzeigevorrichtung umfasst ein formflexibles Anzeigeelement 2 in Form eines klappbaren Smartphones mit einem daran befestigten Schutzglasverbund 3.

Das Anzeigeelement 2 weist zwei zueinander um eine Schwenkachse 4 schwenkbare Teilelemente 5 auf. Die Teilelemente 5 sind fest, aber beweglich miteinander verbunden. Die Teilelemente 5 sind im Wesentlichen identisch ausgeführt. Jedes Teilelement 5 umfasst ein Gehäuseteil und ein darin gehaltenes Anzeigeteilelement 6. Die Anzeigeteilelemente 6 sind gemäß dem gezeigten Ausführungsbeispiel als OLED-Displays ausgeführt. Fig. 1 zeigt das Anzeigeelement 2 in einem teilweise aufgeklappten Zustand. Der Öffnungswinkel zwischen den beiden Teilelementen 5 bezüglich der Schwenkachse 4 beträgt etwa 120°. Insbesondere ermöglicht das Anzeigeelement 2 eine Schwenkbarkeit der Teilelemente 5 zueinander in einem Schwenkwinkelbereich von 0° bis 180°. Der Schwenkwinkelbereich kann auch größer sein als 180° und insbesondere bis zu 360° betragen. Die Teilelemente 5 bilden einen äußeren Rahmen des Anzeigeelements 2.

Die Anzeigeteilelemente 6 bilden eine gemeinsame Anzeigefläche. An der Anzeigefläche ist der Schutzglasverbund 3 angeklebt. Der Schutzglasverbund 3 gewährleistet einen robusten und insbesondere kratzfesten Schutz des Anzeigeelements 2, insbesondere der Anzeigefläche der Anzeigenteilelemente 6. Die Anzeigeteilelemente 6 sind in den Teilelementen 5, also in dem Rahmen, eingefasst. Der Rahmen 5 ist dicker als die Anzeigeteilelemente 6, sodass bei einem Schwenkwinkel von 0° für die Teilelemente 5 kein scharfer Knick der Anzeigeteilelemente 6 an der Schwenkachse 4 vorliegt. Insbesondere sind die Anzeigeteilelemente 6 mit einem Radius zueinander verbunden.

Die Anzeigeteilelemente 6 sind gemäß dem gezeigten Ausführungsbeispiel jeweils an den aneinander zugewandten Innenseiten des Anzeigeelements 2 angeordnet. Wenn das Anzeigeelement 2 zugeklappt ist, also bei einem Schwenkwinkel von 0°, liegen die Anzeigeteilelemente 6 benachbart zueinander an, insbesondere einander berührend. Im zugeklappten Zustand des Anzeigeelements 2 sind die Anzeigeteilelemente 6 insbesondere nicht sichtbar.

Alternativ oder zusätzlich können die Anzeigeteilelemente 6 auch an Au-ßenseiten des Anzeigeelements 2 angeordnet sein.

Alternativ kann die Anzeigefläche auch durch ein einteiliges Anzeigeelement 6 ausgeführt sein. Das einteilige Anzeigeelement 6 erstreckt sich in Längenrichtung des Anzeigeelements 2 über die Schwenkachse 4 hinweg.

Der Schutzglasverbund 3 weist eine entlang der Schwenkachse 4 orientierte Breite B und eine senkrecht dazu orientierte Länge L auf, wobei sich die Länge L aus den Teillängen $L_1$ und $L_2$ der zueinander verschwenkten Teilelemente 5 ergibt.

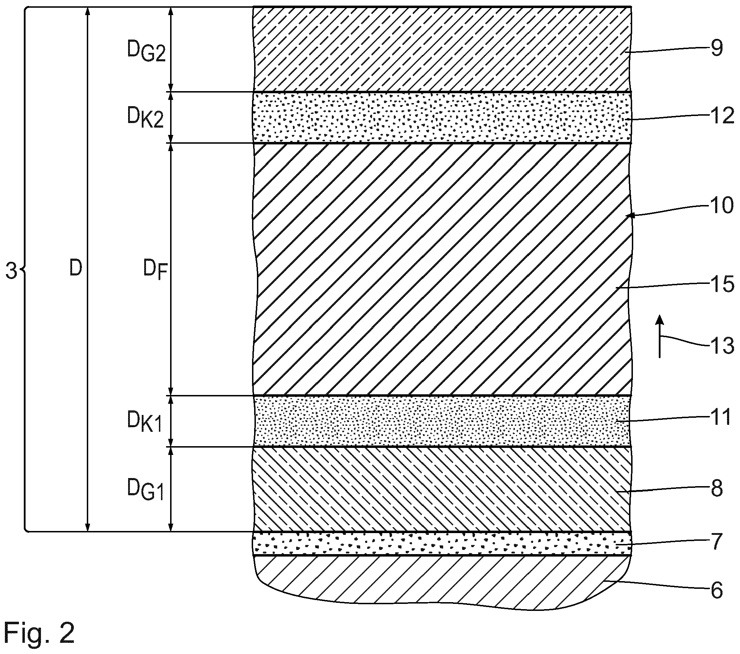

Nachfolgend wird der Aufbau des mehrlagigen Schutzglasverbunds 3 anhand von Fig. 2 näher erläutert. Der Schutzglasverbund 3 ist mittels einer Klebeschicht 7 an den Anzeigeteilelementen 6 angeklebt. Die Klebeschicht 7 weist einen Klebstoff auf Acrylatbasis auf.

Der Schutzglasverbund 3 weist eine erste Dünnglaslage 8 auf, die dem Anzeigeteilelement 6 zugewandt angeordnet ist. Die Klebeschicht 7 verbindet unmittelbar die erste Dünnglaslage 8 mit dem Anzeigeteilelement 6.

Der Schutzglasverbund 3 weist ferner eine zweite Dünnglaslage 9 auf, die gemäß dem gezeigten Ausführungsbeispiel identisch zu der ersten Dünnglaslage 8 ausgeführt ist. Die Dünnglaslagen 8, 9 weisen eine identische Lagendicke auf, $D_{G1} = D_{G2} = 35 \ \mu m$. Die Dünnglaslagen 8, 9 sind aus demselben Material, insbesondere aus Borosilikatglas, ausgeführt.

Alternativ können die Dünnglaslagen 8, 9 unterschiedlich ausgeführt sein, insbesondere unterschiedliche Lagendicken und/oder unterschiedliche Materialien aufweisen.

Die Dünnglaslagen 8, 9 sind bezüglich des Schutzglasverbundes 3 jeweils außenliegend ausgeführt. Die Dünnglaslagen 8, 9 sind jeweils als außenliegende Abschlusslage ausgeführt.

Zwischen den Dünnglaslagen 8, 9 ist eine Polymerschicht 10 angeordnet. Die Polymerschicht 10 weist gemäß dem gezeigten Ausführungsbeispiel eine Polyesterfolie auf.

Gemäß dem gezeigten Ausführungsbeispiel weist die Polymerfolie 15 eine Foliendicke $D_F$ von 100 $\mu m$ auf. Die Polymerschicht 10 kann auch mehrere Polymerfolien 15 aufweisen, die dann insbesondere jeweils unmittelbar miteinander verklebt sind.

Die Polymerschicht 10 ist mittels einer ersten Klebeschicht 11 mit der ersten Dünnglaslage 8 und mittels einer zweiten Klebeschicht 12 mit der zweiten Dünnglaslage 9 unmittelbar verklebt.

Gemäß dem gezeigten Ausführungsbeispiel sind die Klebeschichten 11, 12 identisch ausgeführt, also mit der identischen Schichtdicke $D_{K1} = D_{K2} = 20 \ \mu m$. Die Klebeschichten 11, 12 weisen als Klebematerial jeweils einen Klebstoff auf Acrylatbasis, insbesondere Cyanacrylat, auf.

Es ist denkbar, die Klebeschichten 11, 12 unterschiedlich auszuführen und insbesondere aus unterschiedlichen Materialien und/oder mit unterschiedlichen Schichtdicken $D_{K1}$, $D_{K2}$ auszuführen.

Der Schutzglasverbund 3 weist eine sich entlang der Dickenrichtung 13 erstreckende Dicke D auf, die gemäß dem gezeigten Ausführungsbeispiel 210 $\mu m$ beträgt.

Vorteilhaft ist es, wenn zumindest die außenliegende, zweite Dünnglaslage 9 aus Einscheibensicherheitsglas hergestellt ist. Zusätzlich kann auch die innenliegende, erste Dünnglaslage 8 aus Einscheibensicherheitsglas hergestellt sein.

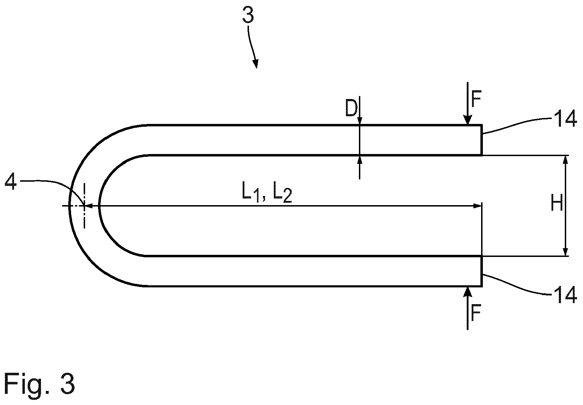

Nachfolgend wird anhand von Fig. 3 die Formflexibilität des Schichtverbundes 3 näher erläutert. Fig. 3 zeigt eine Seitenansicht des Schutzglasverbundes 3 in einer Ebene senkrecht zu der Schwenkachse 4 gemäß Fig. 1.

Die Formflexibilität ist bei dem Schutzglasverbund mit einem Biegeverfahren ermittelt worden. Aus Darstellungsgründen ist das Anzeigeelement 2 nicht dargestellt. Bei dem Biegeversuch werden die freien Enden 14 des flächigen Schutzglasverbundes 3 aufeinander zu bewegt und dadurch der Schutzglasverbund 3 in eine U-Form gebogen. Der Biegevorgang wird durch äußere Krafteinleitung F initiiert.

Versuche der Anmelderin haben gezeigt, dass der erfindungsgemäße Schutzglasverbund 3 derart formflexibel ist, dass er in die in Fig. 3 schematisch dargestellte U-Form gebogen werden kann, wobei der Abstand H der freien Enden 14 zueinander 3 mm beträgt.

In Anlehnung an Dreipunkt-Biegeversuch gemäß DIN EN ISO 178 und DIN EN ISO 14125 ergibt sich eine rechnerische elastische Dehngrenze von

$$\varepsilon_f = \frac{600 \cdot L_1 \cdot D}{H^2}$$

Entsprechend gilt für den Schutzglasverbund 3: $\varepsilon_f = 840$, wobei die Länge $L_1 = 6$ cm, D = 210 $\mu m$ und H = 3 mm.

Für den erfindungsgemäßen Schutzglasverbund ist die Biegung in die U-Form gemäß Fig. 3 möglich, ohne dass der Schutzglasverbund Beschädigungen in Form von Rissen und/oder Brüchen aufwies. Eine Delamination der einzelnen Lagen bzw. Schichten findet nicht statt.

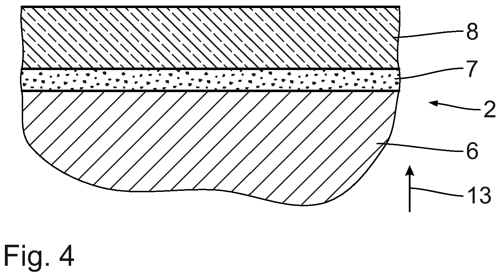

Nachfolgend wird anhand der Fig. 4 die Verwendung der Dünnglaslage 8 als Schutzglas an einem formflexiblen Anzeigeelement 2 erläutert.

Das Anzeigeelement 2 weist gemäß dem gezeigten Ausführungsbeispiel insbesondere ein einziges, durchgängiges Anzeigeelement 6 in Form eines OLED-Displays auf.

Die Dünnglaslage 8 weist gemäß dem gezeigten Ausführungsbeispiel eine Lagendicke $D_{G1}$ von 35 $\mu$m auf.

Die Dünnglaslage 8 ist mittels eines Acrylatklebers, der die Klebeschicht 7 bildet, unmittelbar an dem Anzeigeelement 2 verklebt.

Die Dünnglaslage 8 bildet eine äußere Barriereschicht, um die Struktur des OLED-Displays vor Eindringen von Feuchtigkeit zu schützen. Die Dünnglaslage 8 weist eine erhöhte Kratzbeständigkeit auf. Dadurch, dass die Dünnglaslage 8 eine reduzierte Lagendicke aufweist, treten ausschließlich in Dickenrichtung 13 durchgängige Splitter bei einer möglichen Beschädigung auf. Eine Zerstörung der Dünnglaslage 8 in Dickenrichtung 13, also beispielsweise durch Ablösen von Splitterschichten innerhalb der Dünnglasschicht 8, die keinen unmittelbaren Kontakt zu der Klebeschicht 7 haben, tritt nicht auf. Die durchgängigen Splitter der Dünnglaslage 8 sind zuverlässig an der Klebeschicht 7 gehalten. Eine an der Außenseite der Dünnglasschicht 8 angeordnete Polymerschicht zur Splitterbindung ist nicht erforderlich. Die erfindungsgemäße Verwendung der Dünnglaslage 8 als Schutzglas ist unkompliziert, zuverlässig und robust. Die Dünnglaslage 8 ist insbesondere aus Einscheibensicherheitsglas hergestellt.

**Patentansprüche**

1. Mehrlagiger Schutzglasverbund, wobei der Schutzglasverbund (3) mindestens eine Dünnglaslage (8, 9) und eine mit der mindestens einen Dünnglaslage (8, 9) verbundene Polymerschicht (10) umfasst, wobei der Schutzglasverbund (3) eine Dicke (D) aufweist, die kleiner ist als 1000 $\mu$m.

2. Schutzglasverbund gemäß Anspruch 1, **dadurch gekennzeichnet, dass** die Polymerschicht (10) mindestens eine Polymerfolie (15) aufweist, wobei insbesondere die Polymerschicht (10) eine Polymerfolie (15) oder einen Polymerfolienverbund aus mehreren miteinander verbundenen Polymerfolien (15) aufweist, wobei die Polymerfolie (15) oder Polymerfolienverbund unmittelbar mit der mindestens einen Dünnglaslage (8, 9) verklebt ist.

3. Schutzglasverbund gemäß Anspruch 2, **dadurch gekennzeichnet, dass** die mindestens eine Polymerfolie (15) ein Kunststoffpolymer aufweist, insbesondere mit Homopolymeren und/oder mit Copolymeren.

4. Schutzglasverbund gemäß einem der Ansprüche 2 oder 3, **dadurch gekennzeichnet, dass** die mindestens eine Polymerfolie (15) eine Foliendicke ($D_F$) von weniger als 1.000 $\mu$m, insbesondere weniger als 800 $\mu$m, insbesondere weniger als 500 $\mu$m, insbesondere weniger als 300 $\mu$m, 200 $\mu$m, insbesondere weniger als 180 $\mu$m, insbesondere weniger als 150 $\mu$m, insbesondere weniger als 120 $\mu$m, insbesondere höchstens 100 $\mu$m, insbesondere höchstens 80 $\mu$m, insbesondere höchstens 60 $\mu$m, insbesondere höchstens 50 $\mu$m, insbesondere höchstens 40 $\mu$m, insbesondere höchstens 30 $\mu$m, insbesondere höchstens 20 $\mu$m und insbesondere höchstens 10 $\mu$m aufweist.

5. Schutzglasverbund gemäß einem der vorstehenden Ansprüche,
   **dadurch gekennzeichnet, dass** der Schutzglasverbund rollbar ist.

6. Schutzglasverbund gemäß einem der vorstehenden Ansprüche,
   **dadurch gekennzeichnet, dass** die Polymerschicht (10) in Längen- und/oder in Breitenrichtung einen Randüberstand bezüglich der mindestens einen Dünnglaslage (8, 9) aufweist.

7. Schutzglasverbund gemäß einem der vorstehenden Ansprüche,
   **dadurch gekennzeichnet, dass** der Schutzglasverbund (3) eine erste Dünnglaslage (8) und eine zweite Dünnglaslage (9) aufweist, wobei die Polymerschicht (10) zwischen den Dünnglaslagen (8,9) angeordnet und insbesondere jeweils mit den Dünnglaslagen (8,9) verbunden ist.

8. Schutzglasverbund gemäß einem der vorstehenden Ansprüche,
   **dadurch gekennzeichnet, dass** die Polymerschicht (10) mit der mindestens einen Dünnglaslage (8, 9) unmittelbar verbunden, insbesondere verklebt, ist, wobei insbesondere eine Klebeschicht (11, 12) zwischen der mindestens einen Dünnglaslage (8, 9) und der Polymerschicht (10) angeordnet ist, wobei die Klebeschicht (11, 12) insbesondere eine Schichtdicke ($D_{K1}$, $D_{K2}$) von höchstens 1000 $\mu$m, insbesondere höchstens 800 $\mu$m, insbesondere höchstens 500 $\mu$m, insbesondere höchstens 300 $\mu$m, insbesondere höchstens 200 $\mu$m, insbesondere höchstens 150 $\mu$m, insbesondere höchstens 100 $\mu$m, insbesondere von höchstens 80 $\mu$m, insbesondere von höchstens 60 $\mu$m, insbesondere von höchstens 50 $\mu$m, insbesondere von höchstens 40 $\mu$m, insbesondere von höchstens 30 $\mu$m, insbesondere von höchstens 25 $\mu$m, insbesondere von höchstens 20 $\mu$m, insbesondere höchstens 15 $\mu$m, insbesondere

höchstens 12 $\mu$m, insbesondere höchstens 10 $\mu$m, insbesondere höchstens 8 $\mu$m, insbesondere höchstens 6 $\mu$m, insbesondere höchstens 4 $\mu$m und insbesondere höchstens 2 $\mu$m aufweist.

9. Schutzglasverbund gemäß Anspruch 8, **dadurch gekennzeichnet, dass** die Klebeschicht (11, 12) einen Klebstoff, insbesondere auf Acrylatbasis, aufweist.

10. Schutzglasverbund gemäß einem der vorstehenden Ansprüche,
**dadurch gekennzeichnet, dass** die erste Dünnglaslage (8) und/oder die zweite Dünnglaslage (9) eine Lagendicke ($D_{G1}$, $D_{G2}$) von höchstens 300 $\mu$m beträgt, insbesondere von höchstens 250 $\mu$m, insbesondere von höchstens 200 $\mu$m, insbesondere von höchstens 150 $\mu$m, insbesondere von höchstens 120 $\mu$m, insbesondere von höchstens 100 $\mu$m, insbesondere von höchstens 90 $\mu$m, insbesondere von höchstens 75 $\mu$m, insbesondere von höchstens 60 $\mu$m, insbesondere von höchstens 50 $\mu$m, insbesondere von höchstens 45 $\mu$m, insbesondere von höchstens 40 $\mu$m, insbesondere von höchstens 35 $\mu$m, insbesondere von höchstens 30 $\mu$m, insbesondere von höchstens 25 $\mu$m, insbesondere von höchstens 20 $\mu$m, insbesondere höchstens 15 $\mu$m, insbesondere höchstens von 12 $\mu$m, insbesondere höchstens von 10 $\mu$m, insbesondere höchstens von 8 $\mu$m und insbesondere höchstens von 5 $\mu$m aufweisen.

11. Schutzglasverbund gemäß einem der vorstehenden Ansprüche,
**dadurch gekennzeichnet, dass** die Dünnglaslagen (8, 9) identisch ausgeführt sind.

12. Schutzglasverbund gemäß einem der Ansprüche 1 bis 10, **dadurch gekennzeichnet, dass** die Dünnglaslagen (8, 9) unterschiedlich ausgeführt sind.

13. Schutzglasverbund gemäß einem der vorstehenden Ansprüche,
**dadurch gekennzeichnet, dass** die mindestens eine Dünnglaslage (8, 9) aus Einscheibensicherheitsglas hergestellt ist.

14. Anzeigevorrichtung mit einem formflexiblen Anzeigeelement (2) und mit einem daran befestigten Schutzglasverbund (3) gemäß einem der vorstehenden Ansprüche.

15. Verwendung einer Dünnglaslage (8) als Schutzglas, insbesondere für ein formflexibles Anzeigeelement (2), wobei die Dünnglaslage (8) an dem Anzeigeelement (2) befestigt, insbesondere verklebt ist, wobei die Dünnglaslage (8) eine Lagedicke ($D_{GL1}$, $D_{GL2}$) von höchstens 300 $\mu$m, insbesondere von höchstens 250 $\mu$m, insbesondere von höchstens 200 $\mu$m, insbesondere von höchstens 150 $\mu$m, insbesondere von höchstens 120 $\mu$m, insbesondere von höchstens 100 $\mu$m, insbesondere höchstens 90 $\mu$m, insbesondere höchstens 75 $\mu$m, insbesondere höchstens 60 $\mu$m, insbesondere höchstens 50 $\mu$m, insbesondere höchstens 45 $\mu$m, insbesondere höchstens 40 $\mu$m und insbesondere höchstens 35 $\mu$m, insbesondere höchstens 30 $\mu$m, insbesondere höchstens 25 $\mu$m, insbesondere höchstens 20 $\mu$m, insbesondere höchstens 15 $\mu$m, insbesondere höchstens 12 $\mu$m insbesondere höchstens 10 $\mu$m, insbesondere höchstens 8 $\mu$m und insbesondere höchstens 5 $\mu$m, und wobei die Dünnglaslage (8) insbesondere aus Einscheibensicherheitsglas hergestellt ist.

EP 3 912 808 A1

Fig. 1

Fig. 2

Fig. 3

Fig. 4

Europäisches
Patentamt

European
Patent Office

Office européen
des brevets

## EUROPÄISCHER TEILRECHERCHENBERICHT

nach Regel 62a und/oder 63 des Europäischen Patentübereinkommens. Dieser Bericht gilt für das weitere
Verfahren als europäischer Recherchenbericht.

**Nummer der Anmeldung**

EP 21 16 9056

### EINSCHLÄGIGE DOKUMENTE

| Kategorie | Kennzeichnung des Dokuments mit Angabe, soweit erforderlich der maßgeblichen Teile | Betrifft Anspruch | KLASSIFIKATION DER ANMELDUNG (IPC) |
|---|---|---|---|
| X | WO 2004/001661 A2 (DAVID ALBERT M [CA]) 31. Dezember 2003 (2003-12-31) | 1-4,6, 8-10,13, 15 | INV. B32B17/10 |
| A | * Seite 5, Zeile 26 - Seite 8, Zeile 12 * | 5,7,11, 12,14 | |
| | ----- | | |
| X | DE 699 19 062 T2 (CAMBRIDGE DISPLAY TECH LTD [GB]) 21. Juli 2005 (2005-07-21) | 1-6, 8-10,13, 15 | |
| Y | * Absatz [0007] - Absatz [0011] * <br> * Absatz [0019] - Absatz [0031] * <br> * Absätze [0034], [0035] * | 1-15 | |
| | ----- | | |
| X,P | WO 2021/026408 A1 (CORNING INC [US] ET AL.) 11. Februar 2021 (2021-02-11) | 1,5,6,8, 10,14,15 | |
| A,P | * Absatz [0071] - Absatz [0073] * <br> * Beispiele * <br> * Absatz [0117] * <br> * Absatz [0140] - Absatz [0142] * | 2-4,7,9, 11-13 | |
| | ----- | | **RECHERCHIERTE SACHGEBIETE (IPC)** |
| Y | US 2015/266272 A1 (LEE KYU-TAEK [KR] ET AL) 24. September 2015 (2015-09-24) <br> * Absatz [0039] - Absatz [0050] * <br> * Absatz [0072] - Absatz [0079] * <br> * Absatz [0086] - Absatz [0090] * | 1-15 | B32B <br> C03C <br> G02F <br> G06F <br> H01L <br> H04M |
| | ----- | | |

### UNVOLLSTÄNDIGE RECHERCHE

Die Recherchenabteilung ist der Auffassung, daß ein oder mehrere Ansprüche, den Vorschriften des EPÜ
nicht entspricht bzw. entsprechen, so daß nur eine Teilrecherche (R.62a, 63) durchgeführt wurde.

Vollständig recherchierte Patentansprüche:

Unvollständig recherchierte Patentansprüche:

Nicht recherchierte Patentansprüche:

Grund für die Beschränkung der Recherche:

Siehe Ergänzungsblatt C

| Recherchenort | Abschlußdatum der Recherche | Prüfer |
|---|---|---|
| Den Haag | 18. Oktober 2021 | Lichau, Holger |

EPO FORM 1503 03.82 (P04E09)

Europäisches
Patentamt

European
Patent Office

Office européen
des brevets

**UNVOLLSTÄNDIGE RECHERCHE
ERGÄNZUNGSBLATT C**

Nummer der Anmeldung

EP 21 16 9056

Vollständig recherchierbare Ansprüche:
        6

Unvollständig recherchierte Ansprüche:
        1-5, 7-15

Grund für die Beschränkung der Recherche:

Im vorliegenden unabhängigen (Erzeugnis-) Anspruch 1 wird beansprucht ein "Mehrlagiger Schutzglasverbund, wobei der Schutzglasverbund (3) mindestens eine Dünnglaslage (8, 9) und eine mit der mindestens einen Dünnglaslage (8, 9) verbundene Polymerschicht (10) umfasst, wobei der Schutzglasverbund (3) eine Dicke (D) aufweist, die kleiner ist als 1000 ?m."
Derartige Verbundmaterialien scheinen jedoch im Stand der Technik in vielfältiger Form bekannt zu sein; neben den bereits vom Deutschen Patent- und Markenamt gegen die Prioritätsanmeldung der vorliegenden Anmeldung zitierten Druckschriften US 2013/000 829 A1, US 2015/266272 A1, und US 2018/181165 A1 seien lediglich exemplarisch genannt die Druckschriften US 6268058 B1, DE 10200131 A1, DE 69806263 T2, JP 2010 042588 A, KR 10 2015 037401 A, US 2018/034001 A1, WO 2018/057774 A1, KR 10 2018 074544 A, WO 2020/010888 A1, WO 2020/041032 A1, WO 2021/000605 A1, und WO 2021/041035 A1.
Insgesamt erschien der höchst relevante druckschriftliche Stand der Technik als derart umfangreich, dass es nicht möglich ist, einen mit Regel 61(1) EPÜ konformen Recherchenbericht zu erstellen, zumal die vorliegende Anmeldung eine unüberschaubare Anzahl an möglichen Änderungen zulässt. Vielmehr hätte lediglich eine kleine und willkürliche Auswahl des relevanten Stands der Technik zitiert werden können, und hätte jede Änderung der Ansprüche während der Sachprüfung eine erneute Recherche erforderlich gemacht.
Da die Stellungnahme der Anmelderin zur Aufforderung nach Regel 63(1) EPÜ keine Hinweise zu enthalten schien, auf welchen Gegenstand die Recherche nach Ansicht der Anmelderin eingeschränkt werden könnte, wurde der Gegenstand der vorliegenden Ansprüche nach Regel 63(2) EPÜ nur insofern recherchiert, als eine Polymerschicht (10) vorliegt, die in Längen- und/oder in Breitenrichtung einen Randüberstand bezüglich der mindestens einen Dünnglaslage (8, 9) aufweist, wie im vorliegenden abhängigen (Erzeugnis-) Anspruch 6 angeführt.

**ANHANG ZUM EUROPÄISCHEN RECHERCHENBERICHT
ÜBER DIE EUROPÄISCHE PATENTANMELDUNG NR.**

EP 21 16 9056

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-10-2021

| Im Recherchenbericht angeführtes Patentdokument | Datum der Veröffentlichung | Mitglied(er) der Patentfamilie | Datum der Veröffentlichung |
|---|---|---|---|
| WO 2004001661 A2 | 31-12-2003 | AU 2003245135 A1 | 06-01-2004 |
| | | CA 2391745 A1 | 25-12-2003 |
| | | US 2004004605 A1 | 08-01-2004 |
| | | US 2008173395 A1 | 24-07-2008 |
| | | US 2011032205 A1 | 10-02-2011 |
| | | WO 2004001661 A2 | 31-12-2003 |
| DE 69919062 T2 | 21-07-2005 | DE 69919062 T2 | 21-07-2005 |
| | | EP 0949850 A1 | 13-10-1999 |
| | | EP 1439741 A2 | 21-07-2004 |
| | | GB 2335884 A | 06-10-1999 |
| | | JP 4332579 B2 | 16-09-2009 |
| | | JP 4577852 B2 | 10-11-2010 |
| | | JP H11329715 A | 30-11-1999 |
| | | JP 2007299770 A | 15-11-2007 |
| | | JP 2008218419 A | 18-09-2008 |
| | | US 6592969 B1 | 15-07-2003 |
| | | US 2003124341 A1 | 03-07-2003 |
| | | US 2006134394 A1 | 22-06-2006 |
| WO 2021026408 A1 | 11-02-2021 | TW 202112699 A | 01-04-2021 |
| | | WO 2021026408 A1 | 11-02-2021 |
| US 2015266272 A1 | 24-09-2015 | KR 20150108991 A | 01-10-2015 |
| | | US 2015266272 A1 | 24-09-2015 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102020205028